# EUROPEAN PATENT APPLICATION

(11) **EP 4 435 448 A1**
(43) Date of publication of application: **25.09.2024**
(21) Application number: 24164585.2
(22) Date of filing: 19.03.2024
(51) Int. Cl.: G01R 31/327

(54) **HIGH-SIDE DRIVER DIAGNOSIS METHOD AND BATTERY SYSTEM**

(30) Priority: 20.03.2023 KR 20230036112
(71) Applicant: Samsung SDI Co., Ltd., Yongin-si, Gyeonggi-do 17084 (KR)
(72) Inventor: Yoo, Kwangmin, 17084 Yongin-si, Gyeonggi-do (KR); Kim, Duck-Hyun, 17084 Yongin-si, Gyeonggi-do (KR); Koo, Kyosung, 17084 Yongin-si, Gyeonggi-do (KR); Seo, Giho, 17084 Yongin-si, Gyeonggi-do (KR); Kim, Hyun, 17084 Yongin-si, Gyeonggi-do (KR); Kim, Keunyoung, 17084 Yongin-si, Gyeonggi-do (KR)
(74) Representative: Gulde & Partner

(57) **Abstract**

A battery system (1, 11, 12) includes a battery pack (100), relays (210, 220, 230, 240) connected to the battery pack (100), a high-side driver, HSD, (310, 310_1, 310_2, 310_3) configured to apply a relay driving voltage (Vrly) to high-sides of the relays (210, 220, 230, 240), and a battery management system, BMS, (400) configured to diagnose the HSD (310, 310_1, 310_2, 310_3) based on a voltage measured from first ends of the relays (210, 220, 230, 240) or the HSD (310, 310_1, 310_2, 310_3).

## Description

### BACKGROUND

### 1 Field

The present disclosure relates to a diagnosis method and a battery system.

### 2 Description of the Related Art

In general, a mechanical relay may be used for opening and closing a high voltage battery output in a battery pack. The mechanical relay may be formed to include a coil stage and a high current stage, and if a current that is greater than a trip current flows through the coil, a magnetic force is generated to connect opposite terminals of the high current stage to allow a current to flow therethrough.

The coil stage may include a large inductive reactance and a low resistance to allow a sufficient excitation current to flow to the coil, and the high-current stage may include a very small resistance to reduce power consumption and heat generation.

A driver that drives such a relay may include a plurality of high-side drivers (HSDs) for driving a plurality of high-side switches between a plurality of relays and a relay driving power supply, and may include a low-side driver (LSD) for driving the low-side switches between the relays and a ground. Various failures may occur in an HSD, a LSD, a relay, a battery, etc. A technique for detecting these failures may be desirable.

### SUMMARY

The present disclosure provides a diagnosis method for a high-side driver and a battery system that are capable of detecting a short circuit between a plurality of pins (hereinafter referred to as a pin-to-pin short circuit) that are for applying signals to drive a plurality of high-side switches.

One or more embodiments of the present disclosure provide a battery system including a battery pack, relays connected to the battery pack, a high-side driver (HSD) configured to apply a relay driving voltage to high-sides of the relays, and a battery management system (BMS) configured to diagnose the HSD based on a voltage measured from first ends of the relays or the HSD.

The battery system may further include a low-side driver (LSD) configured to connect a first node, which is connected to low-sides of the relays, and a ground (e.g., the LSD may be connected between low-sides of the relays and a ground).

The battery system may further include voltage sensors configured to generate voltage measurement signals, wherein the BMS may include a main control unit (MCU) configured to drive the HSD to supply a voltage (e.g., the relay driving voltage) to relay coils corresponding to the relays, and a diagnostic device configured to diagnose the HSD based on the voltage measurement signals.

The voltage sensors may be configured to measure high-side voltages of the relays (e.g., voltages from first ends of the relays), wherein the HSD may include first switching elements configured to apply the relay driving voltage to the relays.

The battery system may further include blocking elements including a diode having an anode connected to a low-side of a corresponding one of the relays, and having a cathode connected to the first node.

The MCU may be further configured to output driving signals (e.g., high-side driving signals) for the first switching elements to the HSD, wherein the HSD may further include drivers for outputting inverted driving signals obtained by inverting the driving signals (e.g., high-side driving signals) for the first switching elements.

The battery system may further include blocking elements including a second switching element including a drain connected to a low-side of a corresponding one of the relays, a source connected to the first node, and a gate for receiving a corresponding one of the inverted driving signals from a corresponding one of the drivers, and a diode having an anode connected to the drain, and a cathode connected to the source.

The voltage sensors may be configured to respectively measure voltages of the relays (e.g., corresponding voltages of the HSD), wherein the MCU may be further configured to generate high-side driving signals corresponding to the relays to transmit them to the HSD, and wherein the HSD may include elements (e.g., "ideal elements") configured to apply the relay driving voltage to the relays, and drivers configured to receive the high-side driving signals from pins to drive the elements.

The elements (e.g., "ideal" elements") may include a first switching element configured to have a drain to which the relay driving voltage is applied, a second switching element configured to have a source connected to a source of the first switching element, and a drain connected to a high-side of one of the relays, a first diode configured to have an anode connected to the source of the first switching element, and a cathode connected to the drain of the first switching element, and a second diode configured to have an anode connected to the source of the second switching element, and a cathode connected to the drain of the second switching element, and wherein the drivers may be further configured to respectively supply voltages (e.g., gate signals) to gates of the first switching elements and to gates of the second switching elements.

One of the voltage sensors may be further configured to generate one of the voltage measurement signals by measuring a voltage from a node to which the source of the first switching element and the source of the second switching element is connected, and to transmit the one of the voltage measurement signals to the diagnostic device.

One or more embodiments of the present disclosure provide a diagnosis method including applying a relay driving voltage to high-sides of relays connected to a battery pack, obtaining voltage signals (e.g., voltage measurement signals) by measuring a voltage from first ends of the relays (e.g., high-side voltages of the relays) or a high-side driver (HSD), and diagnosing the HSD based on the voltage signals.

The diagnosis method may further include connecting a first node, which is connected to low-sides of the relays, and a ground.

The diagnosis method may further include driving the HSD to supply a voltage (e.g., the relay driving voltage) to relay coils corresponding to the relays.

The applying of the relay driving voltage may include applying a driving signal (e.g., a high-side driving signal) to a first switching element connected to a high-side of one of the relays, wherein the first switching element may include a gate to which the driving signal (e.g., the high-side driving signal) is applied, a drain to which the relay driving voltage is applied, and a source connected to a high-side of a corresponding relay of the relays, and wherein the first switching element may be configured to transmit the relay driving voltage to the high-side of the corresponding relay based on the driving signal (e.g., the high-side driving signal).

The applying of the relay driving voltage may further include applying an inverted driving signal, in which the driving signal (e.g., the high-side driving signal) applied to the first switching element connected to the corresponding relay is inverted, to a blocking element connected to a corresponding low-side of the low-sides of the corresponding relay, wherein the blocking element may be connected between the corresponding relay and the first node, respectively, and may include a second switching element, wherein the second switching element may include a gate for receiving the inverted driving signal, a drain connected to the corresponding low-side, and a source connected to the first node, and wherein the second switching element connects the corresponding low-side to the first node based on the inverted driving signal.

The applying of the relay driving voltage may include receiving a high-side driving signal corresponding to a corresponding relay of the relays from a battery management system (BMS), and driving an element (e.g., an "ideal element") to apply the relay driving voltage to the corresponding relay.

The element may include a first switching element including a drain for receiving the relay driving voltage, and a second switching element including a source connected to a source of the first switching element, and a drain connected to a high-side of the corresponding relay, and wherein the driving of the element (e.g., the "ideal element") may include supplying a voltage (e.g., a gate signal) to a gate of the first switching element and to a gate of the second switching element.

The measuring of the voltage may include generating a voltage measurement signal by measuring a voltage from a node to which the source of the first switching element and the source of the second switching element of the element are connected, and transmitting the voltage measurement signal to the BMS.

According to the present disclosure, it is possible to detect occurrence of a short circuit between pins while low-sides of relays are commonly operated and high-sides are independently operated.

According to the present disclosure, reliability of diagnosis may be secured through low-side common operation of the plurality of relays, and not only may complex interfaces be simplified, and high costs may be reduced, but also fault diagnosis of HSD is possible.

According to the present disclosure, an automotive safety integrity level (ASIL) may be improved according to reduction of failures in time (FIT) by broadening a diagnostic area of the battery system.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

FIG. 1 illustrates a block diagram schematically showing a battery system according to one or more embodiments of the present disclosure.
FIG. 2 illustrates a block diagram schematically showing a detailed configuration of the battery system of FIG. 1.
FIG. 3 illustrates a circuit diagram if a blocking element included in the battery system of FIG. 2 includes a diode.
FIG. 4 illustrates an example circuit diagram if a blocking element included in the battery system of FIG. 2 includes a P-channel switch.
FIG. 5 illustrates a block diagram schematically showing an example detailed configuration of the battery system of FIG. 1.
FIG. 6 illustrates an example circuit diagram if an HSD included in the battery system of FIG. 5 includes a blocking element.
FIG. 7 illustrates a flowchart of an HSD diagnosis method using a battery system according to one or more embodiments of the present disclosure.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The present disclosure covers all modifications, equivalents, and replacements within the idea and technical scope of the present disclosure. Further, each of the features of the various embodiments of the present disclosure may be combined with each other, in part or in whole, and technically various interlocking and driving are possible. Each embodiment may be implemented independently of each other or may be implemented together in an association.

It will be understood that when an element, layer, region, or component is referred to as being "connected to" or "(operatively or communicatively) coupled to" another element, layer, region, or component, it can be directly connected to or coupled to the other element, layer, region, or component, or indirectly connected to or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or intervening layers, regions, or components may be present. However, "directly connected/directly coupled" refers to one component directly connecting or coupling another component without an intermediate component.

It will be understood that when an element or layer is referred to as being "between" two elements or layers, it can be the only element or layer between the two elements or layers, or one or more intervening elements or layers may also be present.

For the purposes of this disclosure, expressions, such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expression, such as "at least one of A and B" and "at least one of A or B" may include A, B, or A and B. As used herein, "or" generally means "and/or," and the term "and/or" includes any and all combinations of one or more of the associated listed items. For example, the expression, such as "A and/or B" may include A, B, or A and B. Similarly, expressions, such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or secondset)," etc., respectively.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

A program implemented as a set of commands embodying a control algorithm suitable for controlling a second element may be installed in a first element for controlling the second element under a specific control condition among elements according to one or more embodiments. A control element may process input data and stored data depending on an installed program to generate output data. The control element may include a non-volatile memory to store a program and a memory to store data.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

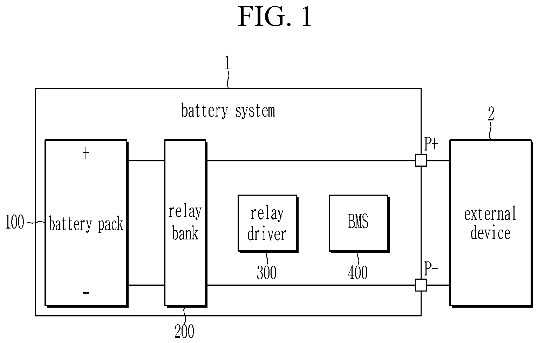

FIG. 1 illustrates a block diagram schematically showing a battery system according to one or more embodiments of the present disclosure.

The battery system 1 may include a battery pack 100, a relay bank (e.g., relay unit) 200, a relay driver 300, and a battery management system (BMS) 400.

An external device 2 may include a load, such as an inverter or a converter and/or a charging device. For example, opposite ends P+ and P- of the battery system 1 may be connected to a charger to receive power from the charger and may be charged. In one or more embodiments, both ends P+ and P- of the battery system 1 may be connected to a load to allow a power supplied by the battery pack 100 to be discharged through the load.

The battery pack 100 may include a plurality of battery cells connected in series and/or in parallel.

The relay bank 200 may include a plurality of relays connected to the battery pack 100. A first end of the relay bank 200 may be connected to the battery pack 100, and a second end of the relay bank 200 may be connected to one of opposite ends of the battery system 1. The relay bank 200 may include a plurality of relays among at least one first relay connected between a first end (+ terminal) of the battery pack 100 and a first end (P+) of the battery system 1, and may include at least one second relay connected between the other end (- terminal) of the battery pack 100 and a second end (P-) of the battery system 1. Hereinafter, a number of relays included in the relay bank 200 will be described as plural.

The relay driver 300 may drive the relay bank 200 under control of the BMS 400. The relay driver 300 may include a plurality of high-side drivers (HSDs) and low-side drivers (LSDs). The HSDs may drive a high-side switch between a plurality of relays included in the relay driver 300 and a relay driving voltage for driving the relays. The LSDs may drive a low-side switch between the multiple relays and a ground.

The relay driver 300 may drive each of the relays included in the relay bank 200 at a high-side of each of the relays while commonly operating a low-side of the relay bank 200. The relay driver 300 may include a blocking element in a high-side channel corresponding to each of the relays. The relay driver 300 enables independent diagnosis of the HSDs corresponding to the relays by blocking a voltage and/or a current through a blocking element corresponding to the remaining relays with the exception of one relay to be monitored among the relays.

The BMS 400 may control an operation of the relay driver 300, and may diagnose a plurality of HSDs. The BMS 400 may control an operation of the relay driver 300, including, for example, a plurality of HSDs, LSDs, and blocking elements. The BMS 400 also may monitor a voltage and/or a current in the relay bank 200 and/or the relay driver 300. The BMS 400 also may diagnose the relay driver 300 based on a measured voltage. The BMS 400 may measure voltages from first ends of the relays included in the relay bank 200, and may measure currents from wires included in the relay driver 300. The BMS 400 may diagnose a state of the HSDs included in the relay driver 300 by diagnosing the relay driver 300.

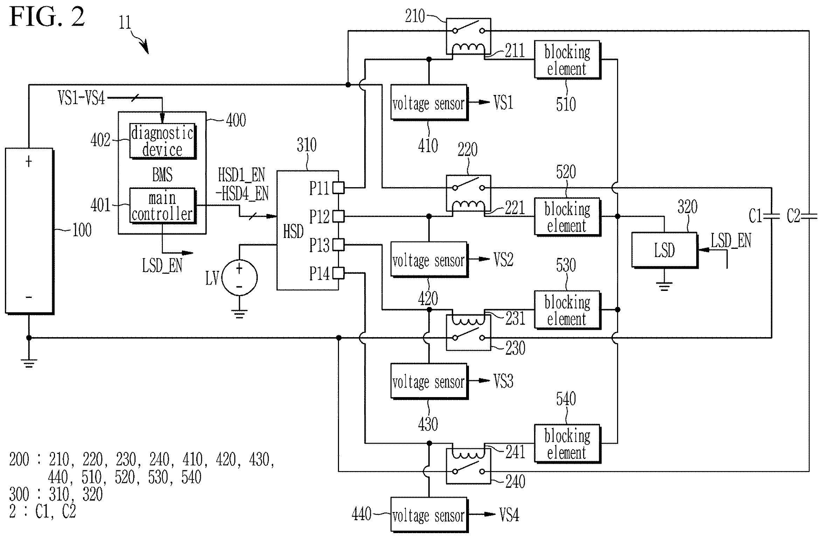

FIG. 2 illustrates a block diagram schematically showing a detailed configuration of the battery system of FIG. 1.

Hereinafter, a detailed configuration of a battery system 11, which shows an example in which the blocking element is connected to a first end of the relay driver 300 in the battery system 1 of FIG. 1, will be described with reference to FIG. 2.

The battery system 11 illustrated in FIG. 2 is an example of the battery system 1 of FIG. 1. Hereinafter, among descriptions of the battery system 11, descriptions of overlapping portions with those of the battery system 1 may be omitted.

The battery system 11 may include a battery pack 100, a relay bank 200, a relay driver 300, and a BMS 400.

The relay bank 200 may include a plurality of relays 210, 220, 230, and 240, a plurality of voltage sensors 410, 420, 430, and 440, and a plurality of blocking elements 510, 520, 530, and 540. However, the present disclosure is not limited thereto, and in some embodiments, the voltage sensors 410, 420, 430, and 440 may be included in the HSD 310, or may be distinguished from the HSD 310 and the relay 220.

In FIG. 2, the voltage sensors 410, 420, 430, and 440 may respectively measure voltages from first ends of the relays 210, 220, 230, and 240.

The relay driver 300 may include an HSD 310 and an LSD 320. The BMS 400 may include a main control unit (MCU) 401 and a diagnostic device (e.g., a diagnosis unit) 402. The external device 2 may include a capacitor C1 and a capacitor C2.

The relay 210 may be a positive pre-charge relay. A first end of the relay 210 may be connected to a positive terminal (+) of the battery pack 100, and a second end of the relay 210 may be connected to a first end of the capacitor C2. The relay 210 may include a relay coil 211.

The relay 220 may be a positive main relay. A first end of the relay 220 may be connected to a positive terminal (+) of the battery pack 100, and a second end of the relay 220 may be connected to a first end of the capacitor C1. The relay 220 may include a relay coil 221.

The relay 230 may be a negative main relay. A first end of the relay 230 may be connected to a negative terminal (-) of the battery pack 100, and a second end of the relay 230 may be connected to a second end of the capacitor C1. The relay 230 may include a relay coil 231.

The relay 240 may be a negative pre-charge relay. A first end of the relay 240 may be connected to a negative terminal (-) of the battery pack 100, and a second end of the relay 240 may be connected to a second end of the capacitor C2. The relay 240 may include a relay coil 241.

The HSD 310 may supply relay coil voltages to the relay coils 211, 221, 231, and 241.

The HSD 310 may include a plurality of terminals P11, P12, P13, and P14. Each of the terminals P11, P12, P13, and P14 may correspond to a pin of the HSD 310.

A low voltage power source LV may be supplied to the HSD 310. For example, the low voltage power source LV may be an auxiliary voltage of a vehicle.

The MCU 401 may generate and transmit a plurality of high-side driving signals HSD1_EN, HSD2_EN, HSD3_EN, and HSD4_EN to the HSD 310. The MCU 401 may drive the HSD 310 to supply a voltage to each of the relay coils 211, 221, 231, and 241.

The HSD 310 may supply a relay coil voltage to a high-side (first end) of each of the relay coils 211, 221, 231, and 241 through the terminals P11, P12, P13, and P14 according to multiple high-side driving signals HSD1_EN, HSD2_EN, HSD3_EN, and HSD4_EN. For example, upon receiving an on-level high-side driving signal HSD1_EN from the MCU 401, the HSD 310 may apply an on-level relay coil voltage to a high-side of the relay coil 211 through the terminal P11.

A corresponding relay among the relays 210, 220, 230, and 240 (e.g., relay 210) may be turned on by a magnetic field caused by a current flowing in the relay coil (e.g., relay coil 211) to which an on-level relay coil voltage is applied among the relay coils 211, 221, 231, and 241. Hereinafter, among the relays 210, 220, 230, and 240, the relay (e.g., relay 210) to be turned on by the MCU 401 through the high-side driving signals HSD1_EN, HSD2_EN, HSD3_EN, and HSD4_EN is referred to as a target relay.

Each of a plurality of blocking elements 510, 520, 530, and 540 (e.g., blocking element 510) may be connected to a second end of a corresponding relay coil (e.g., relay coil 211) among the relay coils 211, 221, 231, and 241. The blocking elements 510, 520, 530, and 540 may block a voltage supplied to relays other than the target relay among the relays 210, 220, 230, and 240.

In FIG. 2, each of the blocking elements 510, 520, 530, and 540 is shown as being connected to a second end of a corresponding relay coil among the plurality of relay coils 211, 221, 231, and 241, but the present disclosure is not limited thereto. In some embodiments, each of the blocking elements 510, 520, 530, and 540 may be included in the HSD 310 to block a voltage supplied to the remaining relays excluding the target relay among the relays 210, 220, 230, and 240.

In one or more embodiments, in FIG. 2, numbers of the relays 210, 220, 230, 240, of the blocking elements 510, 520, 530, and 540 respectively corresponding to the relays 210, 220, 230, and 240, and of voltage sensors 410, 420, 430, and 440 each were illustrated as four, but this is for convenience of description, and the present disclosure is not limited thereto. The battery system 11 may include a plurality of relays, a plurality of blocking elements, and a plurality of voltage sensors. In some embodiments, a number of the blocking elements may correspond to the number of the relays, and a number of the voltage sensors may also correspond to the number of relays. For example, if there are 4 relays, the battery system 11 may also include 4 blocking elements and 4 voltage sensors.

The MCU 401 may generate and transmit a low-side driving signal LSD_EN to an LSD 320. The LSD 320 may connect low-sides of the relay coils 211, 221, 231, and 241 to the ground according to the low-side driving signal LSD_EN.

A first end (high-side) of each of the relay coils 211, 221, 231, and 241 is connected to the HSD 310, and a second end (low-side) of each of the relay coils 211, 221, 231, and 241 may be connected to the LSD 320.

Among the voltage sensors 410, 420, 430, and 440, a corresponding voltage sensor (e.g., voltage sensor 410) may be provided at a first end of each of the relay coils 211, 221, 231, and 241 (e.g., relay coil 211). The voltage sensor 410 may generate a voltage measurement signal VS1 by measuring a voltage of the relay coil 211 at a first end. The voltage sensor 420 may generate a voltage measurement signal VS2 by measuring a voltage of the relay coil 221 at a first end. The voltage sensor 430 may generate a voltage measurement signal VS3 by measuring a voltage of the relay coil 231 at a first end. The voltage sensor 440 may generate a voltage measurement signal VS4 by measuring a voltage of the relay coil 241 at a first end.

The voltage sensors 410, 420, 430, and 440 may respectively transmit the generated voltage measurement signals VS1, VS2, VS3, and VS4 to the diagnostic device 402. The diagnostic device 402 may diagnose the HSD 310 and/or the relays 210, 220, 230, and 240 based on the plurality of voltage measurement signals VS1, VS2, VS3, and VS4.

In FIG. 2, each of the voltage sensors 410, 420, 430, and 440 is illustrated as only connecting to the first end of the relays 210, 220, 230, and 240, but this is for convenience of description, and the present disclosure is not limited thereto. A voltage sensor may be connected to each of high and low-sides of the relays 210, 220, 230, and 240.

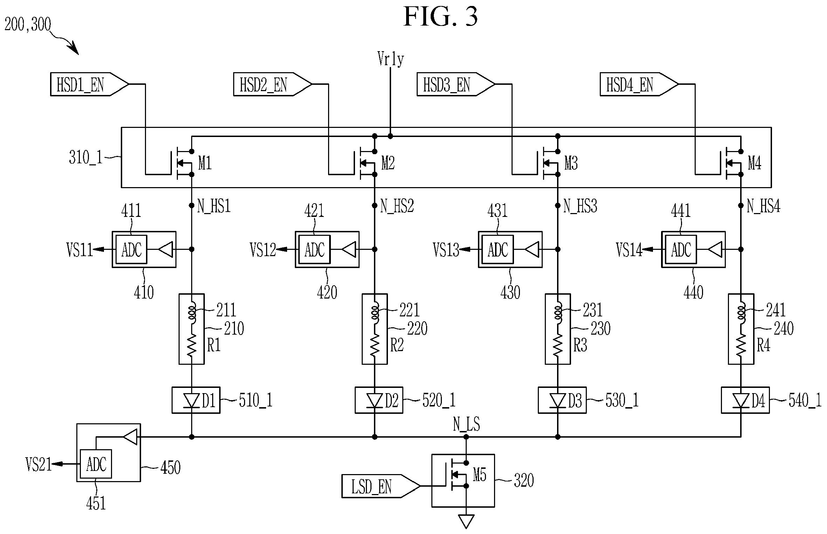

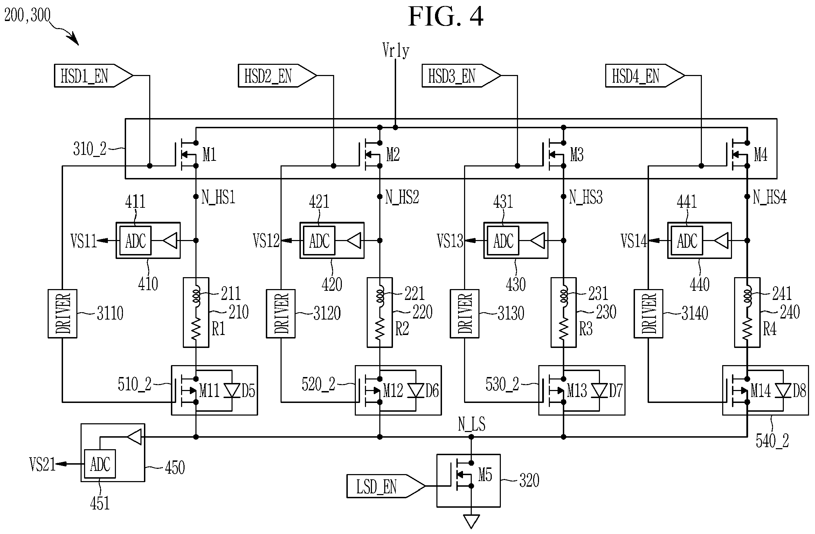

Hereinafter, a circuit diagram of a relay and a relay driver included in the battery system 11 of FIG. 2 will be described with reference to FIG. 3 and FIG. 4.

FIG. 3 illustrates an example circuit diagram if a blocking element included in the battery system of FIG. 2 includes a diode.

Referring to FIG. 3, the relay bank 200 and the relay driver 300 of FIG. 2 may include a plurality of relays 210, 220, 230, and 240, an HSD 310_1, an LSD 320, and a plurality of voltage sensors 410, 420, 430, 440, and 450, and a plurality of blocking elements 510_1, 520_1, 530_1, and 540_1.

The HSD 310_1 of FIG. 3 may be an example of the HSD 310 of FIG. 2, and the blocking elements 510_1, 520_1, 530_1, and 540_1 of FIG. 3 may be an example of the blocking elements 510, 520, 530, and 540 of FIG. 2.

Hereinafter, for better understanding and ease of description, a high-side (first end) of the relay 210 is called a node N_HS1, a high-side (first end) of the relay 220 is called a node N_HS2, a high-side (first end) of the relay 230 is called a node N_HS3, and a high-side (first end) of the relay 240 is referred to as a node N_HS4. In one or more embodiments, a low-side (second end) of each of the relays 210, 220, 230, and 240 is referred to as a node N_LS.

The relay 210 may include a relay coil 211 and a resistor R1. The relay 220 may include a relay coil 221 and a resistor R2. The relay 230 may include a relay coil 231 and a resistor R3. The relay 240 may include a relay coil 241 and a resistor R4.

The HSD 310_1 may include a plurality of switching elements M1, M2, M3, and M4. The switching elements M1, M2, M3, and M4 may be N-channel metal-oxide-semiconductor field effect transistors (MOSFETs). The switching elements M1, M2, M3, and M4 may correspond to the relays 210, 220, 230, and 240.

The switching elements M1, M2, M3, and M4 may respectively receive the high-side driving signals HSD1_EN, HSD2_EN, HSD3_EN, and HSD4_EN from the MCU 401 of FIG. 2 through pins of the HSD 310_1.

The high-side driving signal HSD1_EN may be applied to a gate of the switching element M1. A relay driving voltage Vrly may be applied to the drain of the switching element M1, and the first end of the relay 210 may be connected to a source of the switching element M1. If the on-level high-side driving signal HSD1_EN is applied, a potential difference between a gate and a source becomes more than a threshold voltage (e.g., a predetermined threshold voltage), and thus the switching element M1 is turned on, and the relay driving voltage Vrly may be applied to the relay 210 through the turned-on switching element M1. Hereinafter, the relay driving voltage Vrly of FIG. 3 may be a voltage according to a low voltage power source LV of FIG. 2.

A high-side driving signal HSD2_EN may be applied to a gate of the switching element M2. The relay driving voltage Vrly may be applied to a drain of the switching element M2, and a first end of the relay 220 may be connected to a source of the switching element M2. If the on-level high-side driving signal HSD2_EN is applied, a potential difference between a gate and a source becomes more than a threshold voltage (e.g., a predetermined threshold voltage), and thus the switching element M2 is turned on, and the relay driving voltage Vrly may be applied to the relay 220 through the turned-on switching element M2.

A high-side driving signal HSD3_EN may be applied to a gate of the switching element M3. The relay driving voltage Vrly may be applied to a drain of the switching element M3, and a first end of the relay 230 may be connected to a source of the switching element M3. If the on-level high-side driving signal HSD3_EN is applied, a potential difference between a gate and a source becomes more than a threshold voltage (e.g., a predetermined threshold voltage), and thus the switching element M3 is turned on, and the relay driving voltage Vrly may be applied to the relay 230 through the turned-on switching element M3.

A high-side driving signal HSD4_EN may be applied to a gate of the switching element M4. The relay driving voltage Vrly may be applied to a drain of the switching element M4, and a first end of the relay 240 may be connected to a source of the switching element M4. If the on-level high-side driving signal HSD4_EN is applied, a potential difference between a gate and a source becomes more than a threshold voltage (e.g., a predetermined threshold voltage), and thus the switching element M4 is turned on, and the relay driving voltage Vrly may be applied to the relay 240 through the turned-on switching element M4.

The LSD 320 may include a switching element M5. The switching element M5 may be an N-channel MOSFET. A plurality of switching elements M5 may receive the low-side driving signal LSD_EN from the MCU 401 of FIG. 2.

A low-side driving signal LSD_EN may be applied to a gate of the switching element M5. Second ends of the relays 210, 220, 230, and 240 may be connected to a drain of the switching element M5, and a source of the switching element M5 may be connected to a ground. If the on-level low-side driving signal LSD_EN is applied, the potential difference between the gate and the source becomes equal to or greater than the threshold voltage (e.g., the predetermined threshold voltage), so the switching element M5 may be turned on to connect second ends of the relays 210, 220, 230, and 240 to the ground.

The voltage sensors 410, 420, 430, 440, and 450 may include a plurality of buffers and a plurality of analog-digital converters (ADCs) 411, 421, 431, 441, and 451, respectively. For example, the voltage sensor 410 may include a buffer and an ADC 411.

Each of the ADCs 411, 421, 431, and 441 (e.g., ADC 411) may measure a voltage of a corresponding node (e.g., node N_HS1) among the nodes N_HS1, N_HS2, N_HS3, and N_HS4, and may generate a corresponding voltage measurement signal (e.g., voltage measurement signal VS11) of a plurality of voltage measurement signals VS11, VS12, VS13, and VS14 representing the measured voltage. The ADC 451 may measure the voltage of the node N_LS and may generate a voltage measurement signal VS21 representing the measured voltage.

The ADCs 411, 421, 431, 441, and 451 may respectively transmit the generated voltage measurement signals VS11, VS12, VS13, VS14, and VS21 to the diagnostic device 402 of FIG. 2. The diagnostic device 402 may receive the voltage measurement signals VS11, VS12, VS13, VS14 and VS21, and may diagnose the HSD 310_1 based on them.

The blocking element 510_1 may include a diode D1. An anode of the diode D1 may be connected to the low-side of the relay 210, and a cathode of the diode D1 may be connected to the node N_LS.

The blocking element 520_1 may include a diode D2. An anode of the diode D2 may be connected to the low-side of the relay 220, and a cathode of the diode D2 may be connected to the node N_LS.

The blocking element 530_1 may include a diode D3. An anode of the diode D3 may be connected to the low-side of the relay 230, and a cathode of the diode D3 may be connected to the node N_LS.

The blocking element 540_1 may include a diode D4. An anode of the diode D4 may be connected to the low-side of the relay 240, and a cathode of the diode D4 may be connected to the node N_LS.

The MCU 401 may operate the switching elements M1 to M5 through the high-side driving signals HSD1_EN, HSD2_EN, HSD3_EN, and HSD4_EN and the low-side driving signal LSD_EN, and may supply the relay driving voltage Vrly to a target relay (e.g., relay 210) among the relays 210, 220, 230, and 240. The diagnostic device 402 may derive a high-side voltage of each of the plurality of relays 210, 220, 230, and 240 based on the received voltage measurement signals VS11, VS12, VS13, and VS14.

Hereinafter, a case in which the relay driving voltage Vrly is supplied to the target relay 210 will be described as an example.

Assuming a comparative example in which the relay bank 200 and the relay driver 300 of FIG. 3 do not include the blocking elements 510_1, 520_1, 530_1, and 540_1, a current flowing in the target relay 210 according to the relay driving voltage Vrly may flow to the remaining relays 220, 230, and 240 (e.g., the relays 210, 220, 230, and 240 excluding the target relay 210) through the node N_LS. Because resistance values of the resistors R1, R2, R3, and R4 are relatively very low, the nodes N_HS1, N_HS2, N_HS3, and N_HS4 may exhibit a same voltage value. In the comparative example, the diagnostic device 402 has difficulty determining whether a short circuit between pins of the HSD 310_1 has occurred based on the voltage measurement signals VS12, VS13, and VS14.

In one or more embodiments, referring to FIG. 3, in one or more embodiments, the blocking elements 510_1, 520_1, 530_1, and 540_1 may be included to block a current flowing in the direction of the diodes D1, D2, D3, and D4 from the node N_LS toward the relays 210, 220, 230, and 240, respectively. In one or more embodiments, no current flows from the node N_LS to the remaining relays 220, 230, and 240, and thus the node N_HS1 corresponding to the target relay 210 and the nodes N_HS2, N_HS3, and N_HS4 corresponding to the remaining relays 220, 230, and 240 may indicate different voltage values. In one or more embodiments, the diagnostic device 402 may determine whether a short circuit between the pins of the HSD 310_1 has occurred based on the voltage measurement signals VS12, VS13, and VS14.

For example, if there is a relay (e.g., relay 220) exhibiting a same voltage as the high-side voltage of the target relay (e.g., relay 210) among the high-side voltages of the remaining relays (e.g., relays 220, 230, and 240), the diagnostic device 402 may diagnose that a short circuit between pins corresponding to a corresponding relay (e.g., relay 220) among the pins of the HSD 310_1 has occurred.

In FIG. 3, the relay driver 300 includes an HSD 310_1, the HSD 310_1 includes a plurality of switching elements M1, M2, M3, and M4, and the switching elements M1, M2, M3, and M4 are illustrated as being controlled by the high-side driving signals HSD1_EN, HSD2_EN, HSD3_EN, and HSD4_EN, but the present disclosure is not limited thereto. In some embodiments, the relay driver 300 may include a plurality of HSDs, each of the HSDs may include a switching element, and the switching element included in each of the HSDs may be controlled by the high-side driving signals HSD1_EN, HSD2_EN, HSD3_EN, and HSD4_EN.

FIG. 4 illustrates an example circuit diagram if a blocking element included in the battery system of FIG. 2 includes a P-channel switch.

Among the descriptions of FIG. 4, descriptions of portions overlapping the previous description of FIG. 3 may be omitted.

Referring to FIG. 4, the relay bank 200 and the relay driver 300 of FIG. 2 may include a plurality of relays 210, 220, 230, and 240, an HSD 310_2, an LSD 320, a plurality of voltage sensors 410, 420, 430, 440, and 450, and a plurality of blocking elements 510_2, 520_2, 530_2, and 540_2. The HSD 310_2 of FIG. 4 may be an example of the HSD 310 of FIG. 2, and the blocking elements 510_2, 520_2, 530_2, and 540_2 of FIG. 4 may be an example of the blocking elements 510, 520, 530, and 540 of FIG. 2.

The HSD 310_2 may include a plurality of switching elements M1, M2, M3, and M4 and a plurality of drivers 3110, 3120, 3130, and 3140. The switching elements M1, M2, M3, and M4 may be N-channel MOSFETs. The switching elements M1, M2, M3, and M4 may correspond to the relays 210, 220, 230, and 240.

The switching elements M1, M2, M3, and M4 and the drivers 3110, 3120, 3130, and 3140 may respectively receive the high-side driving signals HSD1_EN, HSD2_EN, HSD3_EN, and HSD4_EN from the MCU 401 of FIG. 2 through pins of the HSD 310_2.

The drivers 3110, 3120, 3130, and 3140 may respectively drive the switching elements M11, M12, M13, and M14 with the high-side driving signals HSD1_EN, HSD2_EN, HSD3_EN, and HSD4_EN received from the pins.

The blocking element 510_2 may include the switching element M11 and the diode D5. A first end of the driver 3110 may be connected to a gate of the switching element M1, and a second end of the driver 3110 may be connected to a gate of the switching element M11. An anode of the diode D5 may be connected to the drain of the switching element M11, and a cathode of the diode D5 may be connected to a source of the switching element M11.

The blocking element 520_2 may include the switching element M12 and the diode D6. A first end of the driver 3120 may be connected to a gate of the switching element M2, and a second end of the driver 3120 may be connected to a gate of the switching element M12. An anode of the diode D6 may be connected to the drain of the switching element M12, and a cathode of the diode D6 may be connected to a source of the switching element M12.

The blocking element 530_2 may include a switching element M13 and a diode D7. A first end of the driver 3130 may be connected to a gate of the switching element M3, and a second end of the driver 3130 may be connected to a gate of the switching element M13. An anode of the diode D7 may be connected to the drain of the switching element M13, and a cathode of the diode D7 may be connected to a source of the switching element M13.

The blocking element 540_2 may include the switching element M14 and the diode D8. A first end of the driver 3140 may be connected to a gate of the switching element M4, and a second end of the driver 3140 may be connected to a gate of the switching element M14. An anode of the diode D8 may be connected to the drain of the switching element M14, and a cathode of the diode D8 may be connected to a source of the switching element M14.

The switching elements M11, M12, M13, and M14 may be P-channel MOSFETs.

If the corresponding high-side driving signal (e.g., HSD1_EN) among the high-side driving signals HSD1_EN, HSD2_EN, HSD3_EN, and HSD4_EN is at an on level, each of the drivers 3110, 3120, 3130, and 3140 (e.g., driver 3110) may supply an on-level voltage to a gate of a corresponding switching element (e.g., switching element M11) among the switching elements M11, M12, M13, and M14.

For example, the drivers 3110, 3120, 3130, and 3140 may generate signals obtained by inverting the high-side driving signals HSD1_EN, HSD2_EN, HSD3_EN, and HSD4_EN enabling the switching elements M1, M2, M3, and M4 (hereinafter referred to as "inverted driving signal"), and may supply an inverted driving signal to gates of the switching elements M11, M12, M13, and M14. In one or more embodiments, the drivers 3110, 3120, 3130, and 3140 may respectively drive the switching elements M1, M2, M3, and M4, which are N-channel MOSFETs, and the switching elements M11, M12, M13, and M14, which are P-channel MOSFETs together.

If the on-level high-side driving signal HSD1_EN is applied, the switching element M1 is turned on, the switching element M11 is turned off, and the diode D5 is conducted, and thus the relay driving voltage Vrly may be applied to the relay 210.

If the on-level high-side driving signal HSD2_EN is applied, the switching element M2 is turned on, the switching element M12 is turned off, and the diode D6 is conducted, and thus the relay driving voltage Vrly may be applied to the relay 220.

If the on-level high-side driving signal HSD3_EN is applied, the switching element M3 is turned on, the switching element M13 is turned off, and the diode D7 is conducted, and thus the relay driving voltage Vrly may be applied to the relay 230.

If the on-level high-side driving signal HSD4_EN is applied, the switching element M4 is turned on, the switching element M14 is turned off, and the diode D8 is conducted, and thus the relay driving voltage Vrly may be applied to the relay 240.

Referring to FIG. 4, the blocking elements 510_2, 520_2, 530_2, and 540_2 may generate less heat by using the switching elements M11, M12, M13, and M14 that are P-channel MOSFET compared to the blocking elements 510_1, 520_1, 530_1, and 540_1 illustrated in FIG. 3. For example, in FIG. 3, heat generated from the blocking element 510_1 is obtained by an equation P_{loss_3} = Vf*IL. Herein, IL indicates a current flowing in the relay coil 211 of the target relay 210, and Vf indicates a diode voltage due to characteristics of diode D1. In one or more embodiments, in FIG. 4, heat generated from the blocking element 510_2 may be obtained by an equation P_{loss_4} =IL²*Rds_on. Herein, IL indicates a current flowing through the relay coil 211 of the target relay 210, and Rds_on indicates a drain-source resistance if the switching element M11 is turned on.

Referring to FIG. 4, in one or more embodiments, the blocking elements 510_2, 520_2, 530_2, 540_2 may be included to block a current flowing in a direction in which the switching elements M11, M12, M13, and M14 and the diodes D5, D6, D7, and D8 are directed from the node N_LS toward the relays 210, 220, 230, and 240, respectively. In one or more embodiments, no current flows from the node N_LS to the remaining relays 220, 230, and 240, and thus the node N_HS1 corresponding to the target relay 210 and the nodes N_HS2 to N_HS4 corresponding to the remaining relays 220, 230, and 240 may indicate different voltage values. In one or more embodiments, the diagnostic device 402 may determine whether a short circuit between the pins of the HSD 310_2 has occurred based on the voltage measurement signals VS12, VS13, and VS14.

In FIG. 4, the relay driver 300 includes an HSD 310_2, the HSD 310_2 includes the switching elements M1, M2, M3, and M4 and the drivers 3110, 3120, 3130, and 3140. The switching elements M1, M2, M3, and M4 and the drivers 3110, 3120, 3130, and 3140 are illustrated to be controlled by the high-side driving signals HSD1_EN, HSD2_EN, HSD3_EN, and HSD4_EN, but the present disclosure is not limited thereto. In some embodiments, the relay driver 300 may include a plurality of HSDs, each of the HSDs may include a switching element and a driver, and the switching element and the driver included in each of the HSDs may be controlled by the high-side driving signals HSD1_EN, HSD2_EN, HSD3_EN, and HSD4_EN.

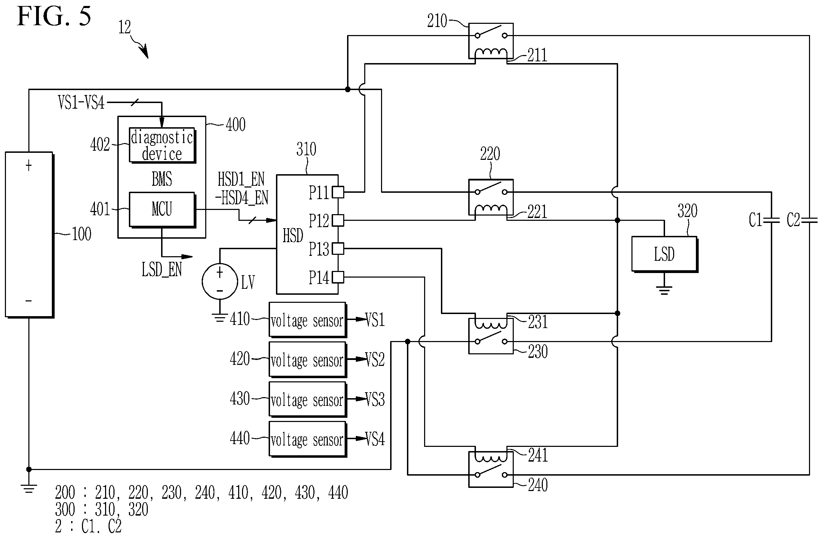

FIG. 5 illustrates a block diagram schematically showing a detailed configuration of the battery system of FIG. 1.

Hereinafter, a detailed configuration of the battery system 12 showing an example in which a blocking element is included in the relay driver 300 in the battery system 1 of FIG. 1 will be described with reference to FIG. 5.

The battery system 12 illustrated in FIG. 5 is an example of the battery system 1 of FIG. 1. Hereinafter, among descriptions of the battery system 12, descriptions of overlapping or repeated portions with those of the battery system 1 or 11 may be omitted.

The battery system 12 may include a battery pack 100, a relay bank 200, a relay driver 300, and a BMS 400.

The relay bank 200 may include a plurality of relays 210, 220, 230, and 240 and a plurality of voltage sensors 410, 420, 430, and 440.

In FIG. 5, the voltage sensors 410, 420, 430, and 440 may measure voltages from a plurality of nodes on the HSD 310.

The relay driver 300 may include an HSD 310 and an LSD 320. The BMS 400 may include an MCU 401 and a diagnostic device 402. The external device 2 may include a capacitor C1 and a capacitor C2.

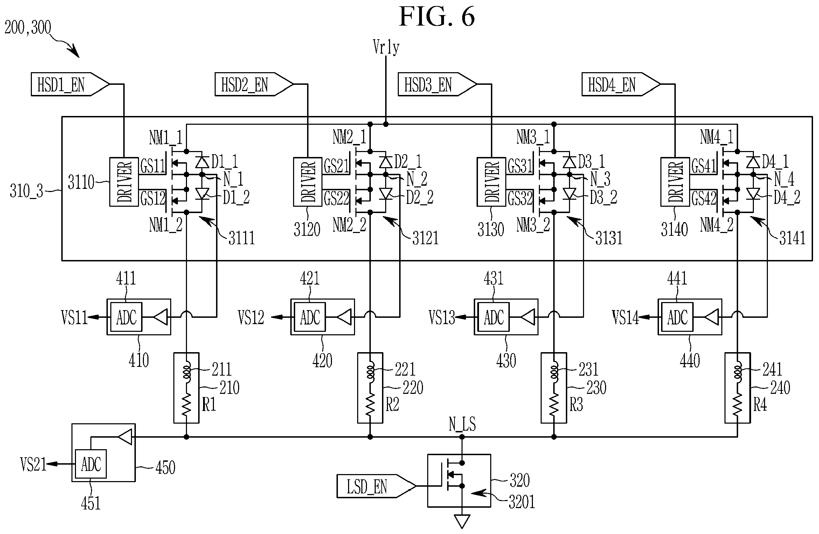

Hereinafter, a circuit diagram of a relay and a relay driver included in the battery system 12 of FIG. 5 will be described with reference to FIG. 6.

FIG. 6 illustrates an example circuit diagram if an HSD included in the battery system of FIG. 5 includes a blocking element.

Referring to FIG. 6, the relay bank 200 and the relay driver 300 of FIG. 5 may include a plurality of relays 210, 220, 230, 240, an HSD 310_3, an LSD 320, and a plurality of voltage sensors 410, 420, 430, 440, and 450.

The HSD 310_3 of FIG. 6 may be an example of the HSD 310 of FIG. 5.

The HSD 310_3 may include a plurality of drivers 3110, 3120, 3130, and 3140 and a plurality of "ideal" (e.g., theoretical) elements 3111, 3121, 3131, and 3141. An "ideal element" may include an "ideal" diode. The "ideal diode" is a two terminal device, which completely allows the electric current without any loss under forward bias, and which completely blocks the electric current with infinite loss under reverse bias.

Referring to FIG. 6, in the battery system 12, the ideal elements 3111, 3121, 3131, and 3141 may block voltages supplied to remaining relays other than the target relay among the relays 210, 220, 230, and 240.

The ideal element 3111 includes two switching elements NM1_1 and NM1_2 and two diodes D1_1 and D1_2. The ideal element 3121 includes two switching elements NM2_1 and NM2_2 and two diodes D2_1 and D2_2. The ideal element 3131 includes two switching elements NM3_1 and NM3_2 and two diodes D3_1 and D3_2. The ideal element 3141 may include two switching elements NM4_1 and NM4_2 and two diodes D4_1 and D4_2. The switching elements NM1_1, NM1_2, NM2_1, NM2_2, NM3_1, NM3_2, NM4_1, and NM4_2 may be N-channel MOSFETs.

The drivers 3110, 3120, 3130, and 3140 may respectively receive the high-side driving signals HSD1_EN, HSD2_EN, HSD3_EN, and HSD4_EN from the MCU 401 of FIG. 5 through pins of the HSD 310_3.

The drivers 3110, 3120, 3130, and 3140 may drive the ideal elements 3111, 3121, 3131, and 3141 with the high-side driving signals HSD1_EN, HSD2_EN, HSD3_EN, and HSD4_EN received from the pins.

The driver 3110 may generate gate signals GS11 and GS12 based on the high-side driving signal HSD1_EN to transmit the gate signals GS11 and GS12 to the ideal element 3111. The driver 3120 may generate gate signals GS21 and GS22 based on the high-side driving signal HSD2_EN to transmit the gate signals GS21 and GS22 to the ideal element 3121. The driver 3130 may generate gate signals GS31 and GS32 based on the high-side driving signal HSD3_EN to transmit the gate signals GS31 and GS32 to the ideal element 3131. The driver 3140 may generate gate signals GS41 and GS42 based on the high-side driving signal HSD4_EN to transmit the gate signals GS41 and GS42 to the ideal element 3141.

Hereinafter, the relay driving voltage Vrly of FIG. 6 may be a voltage according to a low voltage power source LV of FIG. 5.

The gate signal GS11 may be applied to the gate of the switching element NM1_1, and the gate signal GS12 may be applied to a gate of the switching element NM1_2. The relay driving voltage Vrly may be applied to a drain of the switching element NM1_1, and a cathode of the diode D1_1 may be connected thereto. A source of the switching element NM1_1, a source of the switching element NM1_2, an anode of the diode D1_1, and an anode of the diode D1_2 may be connected to the node N_1. A drain of the switching element NM1_2 may be connected to a cathode of the diode D1_2 and one end of the relay 210.

The gate signal GS21 may be applied to the gate of the switching element NM2_1, and the gate signal GS22 may be applied to a gate of the switching element NM2_2. The relay driving voltage Vrly may be applied to a drain of the switching element NM2_1, and a cathode of the diode D2_1 may be connected thereto. A source of the switching element NM2_1, a source of the switching element NM2_2, an anode of the diode D2_1, and an anode of the diode D2_2 may be connected to the node N_2. A drain of the switching element NM2_2 may be connected to a cathode of the diode D2_2 and one end of the relay 220.

The gate signal GS31 may be applied to the gate of the switching element NM3_1, and the gate signal GS32 may be applied to a gate of the switching element NM3_2. The relay driving voltage Vrly may be applied to a drain of the switching element NM3_1, and a cathode of the diode D3_1 may be connected thereto. A source of the switching element NM3_1, a source of the switching element NM3_2, an anode of the diode D3_1, and an anode of the diode D3_2 may be connected to the node N_3. A drain of the switching element NM3_2 may be connected to a cathode of the diode D3_2 and one end of the relay 230.

The gate signal GS41 may be applied to the gate of the switching element NM4_1, and the gate signal GS42 may be applied to a gate of the switching element NM4_2. The relay driving voltage Vrly may be applied to a drain of the switching element NM4_1, and a cathode of the diode D4_1 may be connected thereto. A source of the switching element NM4_1, a source of the switching element NM4_2, an anode of the diode D4_1, and an anode of the diode D4_2 may be connected to the node N_4. A drain of the switching element NM4_2 may be connected to a cathode of the diode D4_2 and one end of the relay 240.

The drivers 3110, 3120, 3130, and 3140 may supply the gate signals GS11, GS12, GS21, GS22, GS31, GS32, GS41, and GS42 to the ideal elements 3111, 3121, 3131, and 3141 based on multiple high-side driving signals HSD1_EN, HSD2_EN, HSD3_EN, and HSD4_EN, respectively.

For example, the driver 3110 may transmit two on-level gate signals GS11 and GS12 to the ideal element 3111 based on the on-level high-side driving signal HSD1_EN. Upon receiving the on-level gate signals GS11 and GS12, the ideal element 3111 may apply the relay driving voltage Vrly to the relay 210.

The voltage sensors 410, 420, 430, 440, and 450 may include a plurality of buffers and a plurality of analog-digital converters (ADCs) 411, 421, 431, 441, and 451. For example, the voltage sensor 410 may include a buffer and an ADC 411.

Each of the ADCs 411, 421, 431, and 441 (e.g., ADC 411) may measure a voltage of a corresponding node (e.g., node N_1) among the nodes N_1, N_2, N_3, and N_4, and may generate a corresponding voltage measurement signal (e.g., voltage measurement signal VS11) of a plurality of voltage measurement signals VS11, VS12, VS13, and VS14 representing the measured voltage. The ADC 451 may measure the voltage of the node N_LS, and may generate a voltage measurement signal VS21 representing the measured voltage.

The ADCs 411, 421, 431, 441, and 451 may transmit the generated voltage measurement signals VS11, VS12, VS13, VS14, and VS21 to the diagnostic device 402 of FIG. 5. The diagnostic device 402 may receive the voltage measurement signals VS11, VS12, VS13, VS14 and VS21, and may diagnose the HSD 310_3 based thereon.

Referring to FIG. 6, a small amount of heat may be generated by using a plurality of switching elements NM1_1, NM1_2, NM2_1, NM2_2, NM3_1, NM3_2, NM4_1, and NM4_2, which are N-channel MOSFETs, as compared to the blocking elements 510_2, 520_2, 530_2, and 540_2 illustrated in FIG. 4. In one or more embodiments, in FIG. 6, heat generated from the ideal element 3111 may be obtained by an equation P_{loss_6} =IL²*Rds_on. Herein, IL indicates a current flowing through the relay coil 211 of the target relay 210, and Rds_on indicates a drain-source resistance if the ideal element 3111 is turned on. In the circuit diagram of FIG. 6, a Rds_on value may be relatively lower than that of the P-channel MOSFET of FIG. 4 by using an N-channel MOSFET.

As described above, referring to FIG. 2 to FIG. 4, the voltage sensors 410, 420, 430, and 440 may measure voltages from first ends of the relays 210, 220, 230, and 240, or, referring to FIG. 5 and FIG. 6, may measure voltages from the nodes N_1, N_2, N_3, and N_4 on the HSD 310.

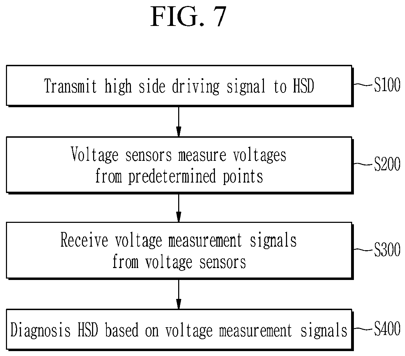

FIG. 7 illustrates a flowchart of an HSD diagnosis method using a battery system according to one or more embodiments of the present disclosure.

Hereinafter, the flowchart of FIG. 7 will be described with reference to the battery system 11 of FIG. 2 and/or the battery system 12 of FIG. 5. Hereinafter, among descriptions of the battery system 11 and/or the battery system 12 of FIG. 5, descriptions of overlapping portions with the previous descriptions may be omitted.

The MCU 401 may transmit the high-side driving signals HSD1_EN, HSD2_EN, HSD3_EN, and HSD4_EN to the HSD 310 (S100).

The blocking elements 510_1, 520_1, 530_1, and 540_1 illustrated in FIG. 3 or the blocking elements 510_2, 520_2, 530_2, and 540_2 illustrated in FIG. 4 may be connected between the relays 210, 220, 230, and 240 and the node N_LS.

In one or more embodiments, referring to FIG. 6, the HSD 310 may include a plurality of ideal elements 3111, 3121, 3131, and 3141.

As such, the battery system 11 including blocking elements 510_1, 520_1, 530_1, 540_1, 510_2, 520_2, 530_2, and 540_2 or the ideal elements 3111, 3121, 3131, and 3141 may block voltage supplied to relays other than the target relay among the relays 210, 220, 230, and 240 through the node N_LS to which low-sides of the relays 210, 220, 230, and 240 are connected.

The voltage sensors 410, 420, 430, and 440 may measure voltages from points (e.g., predetermined points) (S200). The points (e.g., predetermined points) may be a first end of each of the relays 210, 220, 230, and 240, or may be the nodes N_1, N_2, N_3, and N_4 on the ideal elements 3111, 3121, 3131, and 3141 included in the HSD 310_3.

The diagnostic device 402 may receive the voltage measurement signals VS11, VS12, VS13, and VS14 indicating voltages measured by the voltage sensors 410, 420, 430, and 440 (S300). Each of the voltage measurement signals VS11, VS12, VS13, and VS14 may indicate a voltage measured at a point (e.g., a predetermined point) in operation S200.

The diagnostic device 402 may diagnose the HSD 310 based on the received voltage measurement signals VS11, VS12, VS13, and VS14 (S400). For example, in FIG. 3, FIG. 4, or FIG. 6, based on the plurality of voltage measurement signals VS11, VS12, VS13, and VS14 received in a state in which a voltage supplied to relays other than the target relay 210 among the relays 210, 220, 230, and 240 is blocked, the diagnostic device 402 may diagnose a pin-to-pin short-circuit due to a short circuit between a first pin of the HSD 310, which is connected to a wire that transmits the high-side driving signal HSD1_EN to the relay 210, and a second pin of the HSD 310, which is adjacent to the first pin and is connected to a wiring that transmits the high-side driving signal HSD2_EN to the relay 220.

As described above, accuracy of diagnosis for the HSD 310 may be improved by allowing the blocking element 510_1, 520_1, 530_1, 540_1, 510_2, 520_2, 530_2, 540_2, or ideal element 3111, 3121, 3131, 3141 to block the voltage supplied to the relays other than the target relay.

The BMS 400 may repeatedly perform the above-described diagnosis process while changing the target relay to diagnosis a pin-to-pin short-circuit for all pins of the HSD 310 that output high-side driving signals to the relays 210, 220, 230, and 240.

While according to embodiments of the present disclosure have been described in connection with what is presently considered to be practical embodiments, it is to be understood that the disclosure is not limited to the disclosed embodiments, but, on the contrary, is intended to cover various modifications and equivalent arrangements included within the scope of the appended claims, with functional equivalents thereof to be included therein.

### Description of some of the Reference Characters

1, 11, 12: battery system
100: battery pack
200: relay bank
210, 220, 230, 240: relay
211, 221, 231, 241: relay coil
300: relay driver
310, 310_1, 310_2, 310_3: high-side driver (HSD)
3110, 3120, 3130, 3140: driver
3111, 3121, 3131, 3141: ideal element
320: low-side driver (LSD)
400: battery management system (BMS)
410, 420, 430, 440, 450: voltage sensor
411, 421, 431, 441, 451: analog-digital converter (ADC)
510, 510_1, 510_2, 520, 520_1, 520_2,
530, 530_1, 530_2, 540, 540_1, 540_2: blocking element
2: external device

## Claims

1. A battery system (1, 11, 12) comprising:
a battery pack (100);
relays (210, 220, 230, 240) connected to the battery pack (100);
a high-side driver, HSD, (310, 310_1, 310_2, 310_3) configured to apply a relay driving voltage (Vrly) to high-sides of the relays (210, 220, 230, 240); and
a battery management system, BMS, (400) configured to diagnose the HSD (310, 310_1, 310_2, 310_3) based on a voltage measured from first ends of the relays (210, 220, 230, 240) or the HSD (310, 310_1, 310_2, 310_3).

2. The battery system (1, 11, 12) as claimed in claim 1, further comprising:
a low-side driver, LSD, (320) configured to connect a first node (N_LS), which is connected to low-sides of the relays (210, 220, 230, 240) and a ground; and
voltage sensors (410, 420, 430, 440, 450) configured to generate voltage measurement signals (VS1, VS11, VS12, VS13, VS14, VS2, VS21, VS3, VS4),
wherein the BMS (400) comprises:
a main control unit, MCU, (401) configured to drive the HSD (310, 310_1, 310_2, 310_3) to supply a voltage to relay coils (211, 221, 231, 241) corresponding to the relays (210, 220, 230, 240); and
a diagnostic device (402) configured to diagnose the HSD (310, 310_1, 310_2, 310_3) based on the voltage measurement signals (VS1, VS11, VS12, VS13, VS14, VS2, VS21, VS3, VS4).

3. The battery system (1, 11, 12) as claimed in claim 2, wherein the voltage sensors (410, 420, 430, 440, 450) are configured to measure voltages from first ends of the relays (210, 220, 230, 240), and
wherein the HSD (310, 310_1, 310_2, 310_3) comprises first switching elements (M1, M2, M3, M4) configured to apply the relay driving voltage (Vrly) to the relays (210, 220, 230, 240).

4. The battery system (1, 11, 12) as claimed in claim 3, further comprising blocking elements (510, 510_1, 510_2, 520, 520_1, 520_2, 530, 530_1, 530_2, 540, 540_1, 540_2) comprising a diode (D1, D2, D3, D4, D5, D6, D7, D8) having an anode connected to a low-side of a corresponding one of the relays (210, 220, 230, 240), and having a cathode connected to the first node (N_LS).

5. The battery system (1, 11, 12) as claimed in claim 3, wherein the MCU (401) is further configured to output high-side driving signals (HSD1_EN, HSD2_EN, HSD3_EN, HSD4_EN) for the first switching elements (M1, M2, M3, M4) to the HSD (310, 310_1, 310_2, 310_3), and
wherein the HSD (310, 310_1, 310_2, 310_3) further comprises drivers (3110, 3120, 3130, 3140) for outputting inverted driving signals obtained by inverting the high-side driving signals (HSD1_EN, HSD2_EN, HSD3_EN, HSD4_EN) for the first switching elements (M1, M2, M3, M4).

6. The battery system (1, 11, 12) as claimed in claim 5, further comprising blocking elements (510, 510_1, 510_2, 520, 520_1, 520_2, 530, 530_1, 530_2, 540, 540_1, 540_2) comprising:
a second switching element (M11, M12, M13, M14) comprising a drain connected to a low-side of a corresponding one of the relays (210, 220, 230, 240), a source connected to the first node (N_LS), and a gate for receiving a corresponding one of the inverted driving signals from a corresponding one of the drivers (3110, 3120, 3130, 3140); and
a diode (D5, D6, D7, D8) having an anode connected to the drain, and a cathode connected to the source.

7. The battery system (1, 11, 12) as claimed in claim 2, wherein the voltage sensors (410, 420, 430, 440, 450) are configured to respectively measure voltages of the HSD (310, 310_1, 310_2, 310_3),
wherein the MCU (401) is further configured to generate high-side driving signals (HSD1_EN, HSD2_EN, HSD3_EN, HSD4_EN) corresponding to the relays (210, 220, 230, 240) to transmit them to the HSD (310, 310_1, 310_2, 310_3), and
wherein the HSD (310, 310_1, 310_2, 310_3) comprises:
ideal elements (3111, 3121, 3131, 3141) configured to apply the relay driving voltage (Vrly) to the relays (210, 220, 230, 240); and
drivers (3110, 3120, 3130, 3140) configured to receive the high-side driving signals (HSD1_EN, HSD2_EN, HSD3_EN, HSD4_EN) from pins to drive the ideal elements (3111, 3121, 3131, 3141).

8. The battery system (1, 11, 12) as claimed in claim 7, wherein the ideal elements (3111, 3121, 3131, 3141) comprise:
a first switching element (M1_1, M2_1, M3_1, M4_1) configured to have a drain to which the relay driving voltage (Vrly) is applied;
a second switching element (M1_2, M2_2, M3_2, M4_2) configured to have a source connected to a source of the first switching element (M1_1, M2_1, M3_1, M4_1), and a drain connected to a high-side of one of the relays (210, 220, 230, 240);
a first diode (D1_1, D2_1, D3_1, D4_1) configured to have an anode connected to the source of the first switching element (M1_1, M2_1, M3_1, M4_1), and a cathode connected to the drain of the first switching element (M1_1, M2_1, M3_1, M4_1); and
a second diode (D1_2, D2_2, D3_2, D4_2) configured to have an anode connected to the source of the second switching element (M1_2, M2_2, M3_2, M4_2), and a cathode connected to the drain of the second switching element (M1_2, M2_2, M3_2, M4_2), and
wherein the drivers (3110, 3120, 3130, 3140) are further configured to respectively supply gate signals (GS11, GS12, GS21, GS22, GS31, GS32, GS41, GS42) to gates of the first switching elements (M1_1, M2_1, M3_1, M4_1) and to gates of the second switching elements (M1_2, M2_2, M3_2, M4_2).

9. The battery system (1, 11, 12) as claimed in claim 8, wherein one of the voltage sensors (410, 420, 430, 440, 450) is further configured to generate one of the voltage measurement signals (VS1, VS11, VS12, VS13, VS14, VS2, VS21, VS3, VS4) by measuring a voltage from a node (N_1, N_2, N_3, N_4, N_LS) to which the source of the first switching element (M1_1, M2_1, M3_1, M4_1) and the source of the second switching element (M1_2, M2_2, M3_2, M4_2) is connected, and to transmit the one of the voltage measurement signals (VS1, VS11, VS12, VS13, VS14, VS2, VS21, VS3, VS4) to the diagnostic device (402).

10. A diagnosis method comprising:
applying a relay driving voltage (Vrly) to high-sides of relays (210, 220, 230, 240) connected to a battery pack (100);
obtaining voltage measurement signals (VS1, VS11, VS12, VS13, VS14, VS2, VS21, VS3, VS4) by measuring a voltage from first ends of the relays (210, 220, 230, 240) or a high-side driver (3110, 3120, 3130, 3140), HSD, (310, 310_1, 310_2, 310_3); and
diagnosing the HSD (310, 310_1, 310_2, 310_3) based on the voltage measurement signals (VS1, VS11, VS12, VS13, VS14, VS2, VS21, VS3, VS4).

11. The diagnosis method as claimed in claim 10, further comprising:
connecting a first node (N_LS), which is connected to low-sides of the relays (210, 220, 230, 240), and a ground; and
driving the HSD (310, 310_1, 310_2, 310_3) to supply a voltage to relay coils (211, 221, 231, 241) corresponding to the relays (210, 220, 230, 240).

12. The diagnosis method as claimed in claim 11, wherein the applying of the relay driving voltage (Vrly) comprises applying a high-side driving signal (HSD1_EN, HSD2_EN, HSD3_EN, HSD4_EN) to a first switching element (M1, M2, M3, M4) connected to a high-side of one of the relays (210, 220, 230, 240),
wherein the first switching element (M1, M2, M3, M4) comprises a gate to which the high-side driving signal (HSD1_EN, HSD2_EN, HSD3_EN, HSD4_EN) is applied, a drain to which the relay driving voltage (Vrly) is applied, and a source connected to a high-side of a corresponding relay (210, 220, 230, 240) of the relays (210, 220, 230, 240), and
wherein the first switching element (M1, M2, M3, M4) is configured to transmit the relay driving voltage (Vrly) to the high-side of the corresponding relay (210, 220, 230, 240) based on the high-side driving signal (HSD1_EN, HSD2_EN, HSD3_EN, HSD4_EN).

13. The diagnosis method as claimed in claim 12, wherein the applying of the relay driving voltage (Vrly) further comprises applying an inverted driving signal, in which the high-side driving signal (HSD1_EN, HSD2_EN, HSD3_EN, HSD4_EN) applied to the first switching element (M1, M2, M3, M4) connected to the corresponding relay (210, 220, 230, 240) is inverted, to a blocking element (510, 510_1, 510_2, 520, 520_1, 520_2, 530, 530_1, 530_2, 540, 540_1, 540_2) connected to a corresponding low-side of the low-sides of the corresponding relay (210, 220, 230, 240),
wherein the blocking element (510, 510_1, 510_2, 520, 520_1, 520_2, 530, 530_1, 530_2, 540, 540_1, 540_2) is connected between the corresponding relay (210, 220, 230, 240) and the first node (N_LS), respectively, and comprises a second switching element (M11, M12, M13, M14),
wherein the second switching element (M11, M12, M13, M14) comprises a gate for receiving the inverted driving signal, a drain connected to the corresponding low-side, and a source connected to the first node (N_LS), and
wherein the second switching element (M11, M12, M13, M14) connects the corresponding low-side to the first node (N_LS) based on the inverted driving signal.

14. The diagnosis method as claimed in claim 11, wherein the applying of the relay driving voltage (Vrly) comprises:
receiving a high-side driving signal (HSD1_EN, HSD2_EN, HSD3_EN, HSD4_EN) corresponding to a corresponding relay (210, 220, 230, 240) of the relays (210, 220, 230, 240) from a battery management system, BMS, (400); and
driving an ideal element (3111, 3121, 3131, 3141) to apply the relay driving voltage (Vrly) to the corresponding relay (210, 220, 230, 240).

15. The diagnosis method as claimed in claim 14, wherein:
the ideal element (3111, 3121, 3131, 3141) comprises:
a first switching element (M1_1, M2_1, M3_1, M4_1) comprising a drain for receiving the relay driving voltage (Vrly); and
a second switching element (M1_2, M2_2, M3_2, M4_2) comprising a source connected to a source of the first switching element (M1_1, M2_1, M3_1, M4_1), and a drain connected to a high-side of the corresponding relay (210, 220, 230, 240), and
wherein the driving of the ideal element (3111, 3121, 3131, 3141) comprises supplying a gate signal (GS11, GS12, GS21, GS22, GS31, GS32, GS41, GS42) to a gate of the first switching element (M1_1, M2_1, M3_1, M4_1) and to a gate of the second switching element (M1_2, M2_2, M3_2, M4_2); and
wherein the measuring of the voltage comprises:
generating a voltage measurement signal (VS1, VS11, VS12, VS13, VS14, VS2, VS21, VS3, VS4) by measuring a voltage from a node (N_1, N_2, N_3, N_4, N_LS) to which the source of the first switching element (M1_1, M2_1, M3_1, M4_1) and the source of the second switching element (M1_2, M2_2, M3_2, M4_2) of the ideal element (3111, 3121, 3131, 3141) are connected; and
transmitting the voltage measurement signal (VS1, VS11, VS12, VS13, VS14, VS2, VS21, VS3, VS4) to the BMS (400).
